(19) Europäisches Patentamt
European Patent Office
Office européen des brevets

(11) Numéro de publication : **0 569 296 A1**

(12) **DEMANDE DE BREVET EUROPEEN**

(21) Numéro de dépôt : **93401159.4**

(22) Date de dépôt : **05.05.93**

(51) Int. Cl.$^5$ : **H05H 1/46,** C23C 16/42, C23F 1/02, H01J 37/32

(30) Priorité : **07.05.92 FR 9205629**

(43) Date de publication de la demande : **10.11.93 Bulletin 93/45**

(84) Etats contractants désignés : **DE GB NL**

(71) Demandeur : **FRANCE TELECOM**
**Exploitant Autonome de Droit Public, 6, Place d'Alleray**
**F-75015 Paris (FR)**

(72) Inventeur : **Chouan, Yannick**
**1, Allée des Fougères**
**F-22700 Louannec (FR)**
Inventeur : **Le Contellec, Michel**
**3, Hameau du Chêne**
**F-22300 Lannion (FR)**
Inventeur : **Morin, François**
**Le Carpont Lanmerin**
**F-22300 Lannion (FR)**
Inventeur : **Saada, Serge**
**Résidence Beauchamp**
**F-22300 Lannion (FR)**

(74) Mandataire : **Lhoste, Catherine et al**
**SOCIETE DE PROTECTION DES INVENTIONS**
**25, rue de Ponthieu**
**F-75008 Paris (FR)**

(54) **Dispositif et machine à plasma de traitement chimique et procédé utilisant ce dispositif.**

(57) Le dispositif comporte une source HF (2), une enceinte à plasma (4) comportant des alimentations en gaz, une pompe à vide (50), des éléments de couplage de la source à l'enceinte à plasma, cette dernière non rayonnante ayant la forme d'un parallélépipède rectangle avec des première et seconde faces en matériau diélectrique, parallèles à la direction du champ magnétique et une troisième face équipée d'une ouverture rectangulaire (14) parallèle à ce champ pour former un plasma en forme de ruban, une enceinte de traitement contenant un porte-échantillon (18) mobile communiquant via l'ouverture avec l'enceinte à plasma. Les moyens de couplage comportent deux guides (30, 38) d'ondes linéaire de section rectangulaire orientés selon la direction de propagation des ondes et disposés de part et d'autre de l'enceinte à plasma, un cornet (36) pour coupler l'un des guides à l'enceinte à plasma dont la section s'élargit dans le sens du champ magnétique, l'autre guide étant muni d'un court-circuit (46).

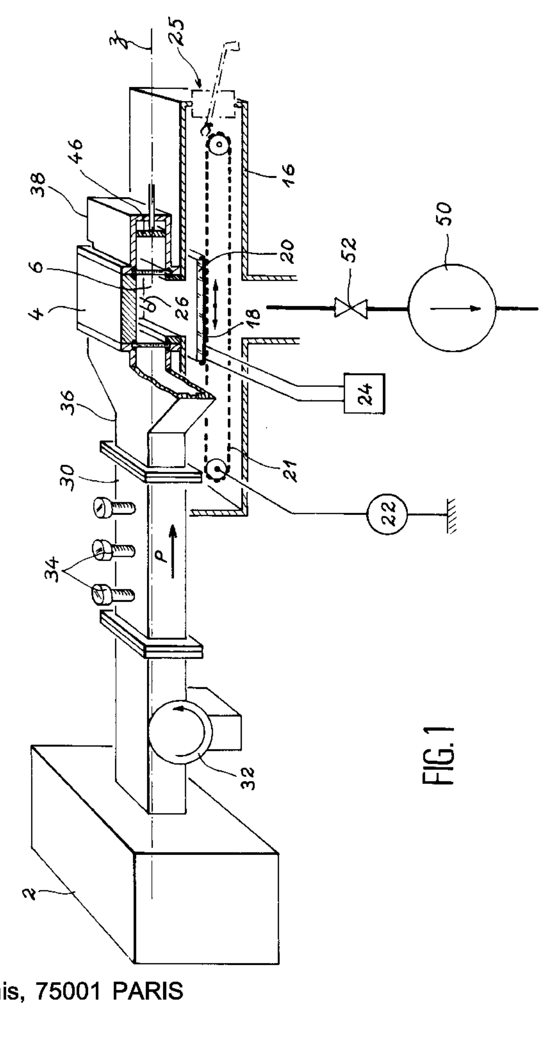


FIG. 1

EP 0 569 296 A1

La présente invention se rapporte à un dispositif à plasma de traitement chimique d'échantillons, à une machine industrielle comportant un ou plusieurs de ces dispositifs ainsi qu'à un procédé utilisant ce dispositif.

En particulier, ce dispositif permet le traitement de surface, le dépôt et la gravure chimique de couches épaisses ou minces sur de grandes surfaces d'echantillons, à des vitesses d'au moins 10 ou 100 fois supérieures à celles obtenues avec les techniques courantes de dépôt et de gravure employées à ce jour.

Elle s'applique en particulier dans le domaine de la microélectronique pour la fabrication de circuits intégrés et de lasers à semi-conducteur, dans le domaine de l'optique intégrée et dans le domaine du solaire pour la conversion photovoltaique de l'énergie lumineuse. Les circuits intégrés auxquels s'applique l'invention sont par exemple des circuits de commande des écrans plats à cristaux liquides.

De façon générale, l'invention s'applique dans tous les domaines industriels nécessitant le dépôt ou la gravure de couches minces ou épaisses, ainsi que le nettoyage chimique de couches ou de substrats. Ces couches et ces substrats peuvent être des diélectriques, des métaux ou des semi-conducteurs.

Il existe actuellement différents types de dispositifs de dépôt et de gravure utilisant un plasma. De façon générale, ces dispositifs comportent une source d'ondes hyperfréquences, une enceinte de traitement fermée étanche contenant un récepteur ou un support destiné à supporter l'échantillon à traiter, des éléments de couplage de la source hyperfréquence à l'enceinte de traitement, des alimentations en gaz destiné à former le plasma et des moyens de pompage de l'enceinte de traitement.

Certains dispositifs de dépôt et de gravure comportent en outre des moyens de création d'un champ magnétique dans l'enceinte de traitement qui interagit avec les ondes hyperfréquences pour ioniser les différents gaz utilisés. Ces dispositifs utilisent la résonance cyclotronique électronique ou "effet ECR". Un tel dispositif est notamment décrit dans le document "Elongated microwave electron cyclotron resonance heating plasma source" de M. Geisler et al. - J. Vac. Sci. Technol., A8(2), mars/avril 1990, pp. 908-915.

Le dispositif de l'invention fait partie de ceux qui n'utilisent pas de champ magnétique et donc d'"effet ECR". Parmi ces dispositifs sans effet ECR, on trouve les dispositifs et machines de dépôt chimique en phase vapeur assisté par un plasma (PECVD).

Ces machines sont actuellement développées pour la fabrication d'écrans plats à matrice active. Elles utilisent en général une fréquence de 13,56MHz.

Ces machines présentent l'inconvénient de mettre en oeuvre des plasmas de faible densité électronique qui ne permettent pas d'obtenir une dissociation totale des gaz. Pour éviter la diffusion d'un gaz non dissocié vers les différents plasmas de dépôt, on isole chaque plasma dans une chambre à vide dédiée au dépôt à réaliser.

Chaque chambre à vide est équipée d'un groupe de pompage qui permet d'obtenir un vide de l'ordre de $10^{-4}$ Pa. Ce groupe à vide est le plus souvent du type turbomoléculaire.

Ces machines de dépôt représentent des équipements complexes dont les coûts d'investissement sont élevés (10 à 20 millions de francs).

De plus, la complexité de ces équipements implique une maintenance régulière qui réduit de manière importante le temps de disponibilité des machines. Enfin, ce sont généralement des équipements de très grandes dimensions qui occupent de grandes surfaces de locaux de type salle blanche limitant ainsi leur application.

Comme autre dispositif sans effet ECR connu, on peut citer celui décrit dans le document EP-A-0 398 832.

Ce dispositif de traitement, bien que moins encombrant que les machines PECVD, présente un certain nombre d'inconvénients. En particulier, sa réalisation est encore complexe augmentant donc son coût de fabrication. De plus, du fait notamment du mode d'injection des gaz plasmagènes, il ne permet pas l'obtention de gravures ou de dépôts sur de grandes surfaces (supérieures à $1dm^2$), de façon homogène.

La présente invention a justement pour objet de nouveaux dispositif et machine à plasma de traitement chimique ainsi qu'un procédé utilisant ce dispositif permettant notamment de remédier à ces inconvénients. En particulier, il permet le dépôt et la gravure chimiques de couches minces, de façon homogène, sur des surfaces de l'ordre du $m^2$ avec des vitesses 10 à 100 fois supérieures à celles utilisées jusqu'à présent.

Par ailleurs, ce dispositif est beaucoup plus simple que les dispositifs à plasma sans "effet ECR" cités précédemment et donc moins coûteux. Il permet la fabrication en grande série à bas coût de circuits intégrés aussi bien dans le domaine de l'optique que de l'électronique.

De façon plus précise, l'invention a pour objet un dispositif à plasma de traitement chimique comportant une source d'ondes électromagnétiques de haute fréquence, une enceinte à plasma fermée, équipée de moyens d'alimentation en gaz destiné à former le plasma, des éléments de couplage de la source à l'enceinte à plasma, des moyens de pompage de l'enceinte à plasma et au moins un porte-échantillon, caractérisé en ce que l'enceinte à plasma est non rayonnante et a la forme d'un parallélépipède rectangle avec une première et une seconde faces en matériau diélectrique, parallèles à une première direction et une troisième face équipée d'une ouverture rectangulaire orientée selon la première direction pour former un plasma en forme de ruban, ladite ouverture mettant en communication l'enceinte à plasma et une enceinte de traitement dans

laquelle est logé le porte-échantillon, en ce que les moyens de couplage comportent un premier guide d'ondes linéaire de section rectangulaire, orienté selon une seconde direction perpendiculaire aux première et seconde faces, un cornet pour coupler le premier guide à l'enceinte à plasma, via la première face, dont la section rectangulaire s'élargit selon la première direction du premier guide vers l'enceinte à plasma, un second guide d'ondes linéaire à section rectangulaire, orienté selon la seconde direction et disposé du côté de l'enceinte à plasma opposé à celui du premier guide, ce second guide étant muni d'un court-circuit auxdites ondes électromagnétiques.

En plus des avantages mentionnés ci-dessus, il permet d'obtenir des vitesses de dépôt élevées, sans effet ECR, de créer des plasmas de forte densité électronique, capables de dissocier la totalité du gaz moléculaire utilisé pour former le plasma.

Les fréquences utilisées sont généralement comprises entre 100MHz et 10GHz et la puissance hyperfréquence utilisée peut aller jusqu'à plusieurs kilowatts.

Le plasma fourni par le dispositif ou le réacteur de l'invention est très stable. En outre, le dispositif de l'invention permet de traiter plusieurs échantillons en chaîne. Dans ce cas, des moyens mécaniques sont prévus pour faire défiler successivement les échantillons à traiter devant l'ouverture rectangulaire de l'enceinte à plasma, parallèlement à la seconde direction.

Le dispositif de l'invention permet aussi le traitement simultané de plusieurs échantillons. En particulier, il est possible de traiter deux échantillons simultanément en utilisant le même plasma gazeux. Pour ce faire, l'enceinte à plasma comporte alors une autre ouverture rectangulaire, orientée selon la première direction et formée dans une quatrième face de l'enceinte à plasma, parallèle à la troisième face mettant en communication l'enceinte à plasma et l'enceinte de traitement et en ce qu'un autre porte-échantillon, logé dans une autre enceinte de traitement est prévu en regard de cette autre ouverture.

De façon avantageuse, le court-circuit du second guide d'ondes est du type piston, ce qui permet d'établir un couplage de l'enceinte à plasma éliminant tout rayonnement électromagnétique de l'enceinte vers l'extérieur de celle-ci. Toute l'énergie micro-onde est ainsi maintenue dans l'enceinte à plasma.

Afin d'améliorer ce couplage, il est possible d'utiliser des vis d'ajustement d'impédance qui pénètrent dans le premier guide d'ondes.

Afin d'obtenir un traitement homogène, par exemple un dépôt ou une gravure homogène sur une grande surface, il est préférable que les moyens d'alimentation en gaz consistent en au moins un tube percé de trous sur toute sa longueur qui débouchent dans l'enceinte à plasma, ce ou ces tubes étant orientés parallèlement à la première direction. En particulier, ce ou ces tubes sont situés à proximité de l'ouverture rectangulaire de l'enceinte à plasma.

Selon l'application envisagée, le dispositif de traitement peut comprendre des moyens de chauffage du ou des porte-échantillons, des moyens de refroidissement de ces porte-échantillons et/ou des moyens de polarisation de ces porte-échantillons.

Le dispositif industriel de l'invention présente de petites dimensions (longueur <1m) par rapport à celles des dispositifs de l'art antérieur, ce qui permet son emploi dans des sites de petites dimensions ne pouvant pas, jusqu'à ce jour, être équipés de ce type d'appareil.

Le dispositif de l'invention peut être utilise pour le dépôt chimique d'une couche mince ou épaisse sur un substrat ; la couche deposée peut avoir une épaisseur > à 10μm. Dans ce cas, on place le substrat dans l'enceinte de traitement sur le porte-échantillon et on le soumet à un plasma précurseur de la couche à déposer, engendré dans l'enceinte à plasma.

Il est aussi possible d'effectuer une gravure chimique des matériaux. Dans ce cas, le matériau à graver est placé dans l'enceinte de traitement sur le porte-échantillon et est soumis à un plasma d'attaque chimique spécifique du matériau à graver.

En plus des avantages mentionnés ci-dessus, le dispositif de l'invention permet, entre chaque traitement, un nettoyage de ce dispositif.

Dans une ligne de production de couches minces, il est couramment admis que le temps nécessaire au nettoyage des enceintes à plasma et de dépôt peut représenter de 10 à 20% du temps d'utilisation de la machine.

Ce nettoyage se fait généralement par brossage mécanique de l'ensemble des pièces "métallisées".

Il est donc judicieux de pouvoir imaginer la réalisation d'un tel nettoyage, sans démontage de la machine, mais en créant dans le dispositif de traitement un plasma adapté permettant de venir graver chimiquement les dépôts recouvrant les parois des enceintes jusqu'à les mettre à nu.

Le principe est connu et est utilisé chez certains constructeurs de réacteurs à plasma du type PECVD à 13,56MHz. Par exemple, on citera à cet effet l'équipement type ND 400 de la Société NEXTRAL.

Dans le dispositif de l'invention, il est avantageusement possible de réaliser un tel nettoyage avec un plasma de gaz rare et d'halogénure excité à 2,45GHz.

Après chaque étape de dépôt, il est donc possible de réaliser un plasma de nettoyage du réacteur. Ce plasma a en plus pour effet de réduire de manière importante la contamination particulaire du réacteur et d'augmenter le rendement d'utilisation du réacteur.

La position relative dans l'enceinte à plasma de ou des tubes perforés peut être ajustée. En particulier, on constate que l'uniformité de l'action du plasma sur le substrat est grandement influencée par la position des tubes d'injection de gaz dans l'enceinte à plasma mais aussi par sa forme.

Ni la forme, ni la position des tubes d'injection de gaz dans l'enceinte à plasma n'affectent la qualité de couplage électromagnétique de cette enceinte. En revanche, la longueur de diffusion des espèces créées dans le plasma est sensible au mode d'injection des gaz dans l'enceinte à plasma. Ceci se traduit par une efficacité d'action et une homogénéité du ruban ou barreau de plasma plus ou moins importante.

Le dispositif de l'invention peut avantageusement être utilisé dans une machine industrielle pour la production à grand rendement de dépôts et de gravures de couches minces.

Aussi, l'invention a encore pour objet une machine industrielle comportant un ou plusieurs dispositifs de l'invention.

En particulier, cette machine industrielle peut être équipée d'une même chambre à vide ou de traitement et de plusieurs dispositifs à plasma travaillant en même temps, à la même pression, mais chacun étant alimenté avec des gaz correspondant à la nature du matériau à traiter, les porte-échantillons de chaque dispositif étant logés dans cette chambre à vide commune.

D'autres caractéristiques et avantages de l'invention ressortiront mieux de la description qui va suivre, donnée à titre illustratif et non limitatif, en référence aux figures annexées, dans lesquelles :

- la figure 1 est une vue génerale en perspective, partiellement coupée d'un dispositif à plasma conforme à l'invention,
- la figure 2 est une partie plus détaillée de la figure 1 montrant, en perspective coupée longitudinalement, l'enceinte à plasma et le cornet du dispositif à plasma,
- la figure 3 est une perspective d'une variante de réalisation du dispositif de la figure 1 montrant le traitement simultané de deux échantillons,
- la figure 4 représente schématiquement en vue de dessus, une machine industrielle comportant trois dispositifs à plasma assemblés, conformes à l'invention,
- les figures 5a et 5b donnent les spectres en unité de masse atomique (uma) d'un plasma de $SiH_4$ obtenu avec le dispositif de l'invention,
- les figures 6a à 6c sont relatives au dépôt du nitrure de silicium hydrogéné réalisé avec le dispositif de l'invention : la figure 6a montre la structure de l'échantillon étudié, la figure 6b est le montage électrique de mesure et la figure 6c donne la caractéristique courant-tension de la structure de la figure 6a,
- la figure 7 est un spectre de transmittance infrarouge d'un film de silicium amorphe hydrogéné déposé avec le dispositif de l'invention,
- les figures 8a, 8b et 9a, 9b sont relatives à des transistors en couches minces réalisés avec le dispositif de l'invention : les figures 8a et 9a donnent les structures des transistors réalisés et les figures 8b et 9b donnent les caractéristiques courant de drain-tension de drain, respectives de ces transistors.

En référence aux figures 1 et 2, on décrit ci-après le dispositif de traitement conforme à l'invention, selon un premier mode de réalisation.

Ce dispositif est en fait un réacteur à plasma comportant une source 2 d'ondes électromagnétiques de haute fréquence, couplée à une enceinte à plasma 4. La source 2 peut délivrer une puissance jusqu'à 2 kW à une fréquence industrielle choisie dans la gamme de 100MHz à 10Ghz (par exemple 433MHz, 915MHz, 2,45GHz, 5,8GHz, 24GHz). En particulier, la fréquence utilisée est 2,45GHz, c'est la plus utilisée et donc celle présentant un coût de revient le plus bas.

L'onde électromagnétique issue de cette source se propage suivant un mode transverse électrique du type $TE_{NO}$ avec N impair ; la direction de propagation $\vec{P}$ est parallèle à l'axe longitudinal z du réacteur. La composante électrique $\vec{E}$ de ce champ est orientée perpendiculairement à la direction $\vec{P}$ selon une direction orientée parallièlement au plan de coupe de la figure 2. Le champ magnétique $\vec{H}$ de l'onde électromagnétique a deux composantes $\vec{H}_x$ et $\vec{H}_z$ perpendiculaires entre elles et situées dans le plan perpendiculaire à la direction du champ électrique, avec $\vec{H}_z$ parallèle à la direction $\vec{P}$ .

En particulier, l'onde électromagnétique se propage suivant le mode fondamental $TE_{10}$.

L'enceinte à plasma 4 définit une chambre à plasma 6 en forme de parallélépipède rectangle. Elle comporte deux parois latérales 8 et 10, parallèles à la direction de la composante $\vec{H_x}$ du champ magnétique (ou perpendiculaires à la direction de propagation) et réalisées en matériau à faible perte diélectrique, comme la silice. Les autres parois de l'enceinte à plasma 4 sont en métal, notamment en aluminium.

La paroi inférieure 12 de l'enceinte à plasma, perpendiculaire aux parois diélectriques 8 et 10 comporte une ouverture rectangulaire 14 dont le grand côté est parallèle aux parois diélectriques 8 et 10. Elle assure la mise en communication de l'enceinte à plasma 4 avec une enceinte de traitement 16 dans laquelle est logé un porte-échantillon 18.

Ce porte-échantillon est mobile selon la direction $\vec{P}$, de propagation de l'onde électromagnétique de façon que la surface de l'échantillon 20 à traiter supporté par le porte-échantillon 18 se déplace devant l'ouverture 14 de l'enceinte à plasma et parallèlement. Le système de déplacement du porte-échantillon 18 peut être du type convoyeur comme ceux classiquement utilisé en microélectronique, par exemple ceux vendus par la société LEYBOLD sous la référence ZW800 (voir figure 3).

Ce porte-échantillon 18 connu peut être polarisé à l'aide d'une source de tension 22 connectée au convoyeur 21. De même, il peut être chauffé à l'aide de systèmes du type résistance électrique alimentée en courant par une source de tension 24, ou être refroidi à l'aide d'un système à circulation de fluide.

L'agencement du système de chauffage ou de refroidissement du porte-échantillon est conforme à l'art antérieur.

Pour l'introduction de l'échantillon 20 à traiter dans l'enceinte de traitement 16, celle-ci est équipée à l'une de ses extrémités d'un système 25 connu du type sas d'introduction.

L'enceinte à plasma 4, représentée sur la figure 2, comporte un tube 26 orienté parallèlement aux parois 8 et 10, destiné à l'injection de gaz à ioniser à l'intérieur de la chambre à plasma 6. Ce tube 26 comporte des trous 28 formés selon l'une de ses génératrices, orientés vers l'ouverture 14 de l'enceinte à plasma et donc vers l'enceinte de traitement 16.

Ce tube 26 est en métal de petite section (typiquement de $10mm^2$) et les trous 28 ont des diamètres différents. Sa position longitudinale par rapport aux parois 8 et 10 est fixe. En revanche, sa position en hauteur par rapport à l'ouverture 14 peut être ajustée. Des moyens mécaniques de réglage en hauteur de la position du tube 26, non représentés, sont donc prévus à l'extérieur du réacteur.

Ainsi, il est possible d'approcher le tube d'injection de gaz très près de l'échantillon 20, par exemple à une distance inférieure à 20mm permettant ainsi le dépôt homogène de couches minces ou épaisses sur l'échantillon à traiter ou inversement la gravure de cet échantillon.

Les dispositifs de l'art antérieur et en particulier celui du document EP-0 398 832 ne permettent pas l'injection du gaz précurseur du plasma aussi près de l'échantillon à traiter et donc le dépôt ou la gravure homogène sur de grandes dimensions ($\geqq 1m^2$).

Les éléments de couplage de l'enceinte à plasma 4 avec la source hyperfréquence 2 comportent (figure 1) un premier guide d'ondes 30 droit de section rectangulaire orienté selon la direction de propagation $\vec{P}$ des ondes, couplé à la source 2 par l'intermédiaire d'un circulateur-isolateur 32 protégeant la source des éventuelles réflexions des ondes hyperfréquences, créées à l'intérieur du réacteur. Cet isolateur n'est pas indispensable au bon fonctionnement du dispositif.

Le premier guide d'ondes 30 est muni de vis d'adaptation 34, pénétrant à l'intérieur du guide, par exemple au nombre de 3, permettant d'adapter l'impédance du réacteur en vue d'obtenir un bon rendement de la transmission des ondes vers l'enceinte à plasma 4.

Le couplage de ce guide d'ondes 30 de l'enceinte à plasma 4 se fait par l'intermédiaire d'un cornet 36 dont la section s'élargit progressivement suivant la direction perpendiculaire à la direction de propagation $\vec{P}$ (ou parallèle à la direction $\vec{H_x}$) et jusqu'à atteindre une section droite rectangulaire égale à celle des parois Latérales 8 et 10 de l'enceinte à plasma 4.

Le couplage du cornet et de l'enceinte à plasma 4 se fait via la paroi 8 en diélectrique. Du côté opposé, on trouve un second guide d'ondes 38 droit, de section égale à celle de la paroi de l'enceinte à plasma 4 en regard. Le couplage entre l'enceinte à plasma 4 et le second guide 38 est assuré via la paroi en diélectrique 10.

Les parois 8 et 10 en diélectrique sont fixées par des systèmes à brides 40 intégrés respectivement aux parois supérieure 42 et inférieure 12 de l'enceinte à plasma, au cornet 36 et au guide d'ondes 38.

L'étanchéité au vide de la chambre à plasma 6 est réalisée à l'aide de joints 44 toriques métalliques souples (par exemple en aluminium).

Le guide terminal 38 est monté en court-circuit aux ondes électromagnétiques et renferme avantageusement un piston 46 capable de se déplacer selon la direction $\vec{P}$ de propagation des ondes. Le système de déplacement du piston (non représenté) peut être du type hydraullque ou pneumatique.

L'ajustement des vis pénétrantes 34 ainsi que la position du piston 46 permet d'établir un couplage de l'enceinte à plasma, non rayonnant, éliminant ainsi tout rayonnement électromagnétique de l'enceinte vers l'extérieur.

Les joints métalliques souples 44 ainsi que le piston 46 jouent le rôle de courts-circuits efficaces vis-à-vis d'un éventuel rayonnement électromagnétique de l'enceinte vers l'extérieur.

Ainsi, toute la puissance électromagnétique est maintenue à l'intérieur de l'enceinte à plasma et donc utilisée pour la formation du plasma.

La paroi interne du cornet 36 est équipée de rugosités 48 à profil en U dont les branches sont parallèles à la direction du champ magnétique $\vec{H_x}$, permettant de corriger une éventuelle erreur sur la phase du champ électrique.

A titre d'exemple, ces motifs 48 présentent une profondeur de $\lambda$ /4 et une hauteur de $\lambda$ /10. Ils permettent de fournir une densité d'énergie électromagnétique la plus uniforme possible à l'intérieur de l'enceinte à plasma.

La dimension des guides d'ondes ainsi que celles du cornet et de l'enceinte à plasma sont fonction de la fréquence des ondes utilisées. Pour une fréquence de 2,45GHz, la longueur d'onde est de 12,2cm.

L'ensemble du dispositif a une longueur relativement faible et inférieure dans tous les cas à 1m.

Comme pour l'enceinte à plasma 4, l'assemblage de l'isolateur 32, du guide d'ondes 30 et du cornet 36 est assuré par des systèmes à brides.

Le réacteur décrit ci-dessus permet la création d'un plasma ainsi que sa production sous forme d'une ligne ou d'un barreau, grâce à l'ouverture 14, dirigé vers l'enceinte de traitement 16.

L'enceinte de traitement 16 est une enceinte à vide reliée à un système de pompage symbolisé en 50. Une vanne de laminage 52 interposée entre l'enceinte à vide 16 et le groupe de pompage 50 permet de créer une conductance variable entre le groupe de pompage et le réacteur à plasma. Elle permet d'ajuster la pression du plasma dans l'enceinte à plasma tout en conservant une vitesse de pompage optimale du groupe de pompage 50.

Les domaines de fonctionnement du réacteur représenté sur les figures 1 et 2 sont ceux obtenus lorsque le réacteur est raccordé à un groupe à vide composé d'un pompe primaire de 63Mh et d'une pompe à diffusion d'huile de 700l/s. Dans ce cas, les volumes internes de la chambre à plasma 4 et de l'enceinte de traitement 16 sont respectivement proches de 2l et de 30l.

Avec le dispositif de traitement de l'invention, il est possible de traiter simultanément deux échantillons avec la même enceinte à plasma au lieu d'un seul, comme représenté sur la figure 3. Dans ce cas, l'enceinte à plasma 4a comporte deux ouvertures latérales rectangulaires 14a et 14b en regard l'une de l'autre, orientées perpendiculairement aux parois en diélectrique 8 et 10 et selon le champ $\vec{E}$ .

En regard de chacune de ces ouvertures latérales 14a et 14b, on trouve un porte-échantillon respectivement 18a et 18b mobile selon la direction de la propagation $\vec{P}$ des ondes électromagnétiques.

Dans ce cas, l'enceinte à plasma 4a comporte deux groupes de tubes d'injection de gaz, un premier groupe 26a disposé en regard de l'ouverture 14a et un second groupe 26b disposé en regard de l'ouverture 14b.

Dans le mode représenté sur la figure 3, on utilise deux tubes d'injection pour chaque échantillon. Il est toutefois possible d'utiliser un seul tube d'injection pour chaque échantillon, comme représenté sur la figure 1.

Inversement, il est possible d'utiliser dans le dispositif de la figure 1 deux tubes d'injection de gaz.

Dans le cas de l'utilisation de deux tubes d'injection de gaz par échantillon, les trous 28 de ces tubes ne sont plus orientés vers l'échantillon à traiter correspondant mais vers le centre de l'enceinte à plasma 4a. Autrement dit, les trous 28 d'une même paire de tubes se font face.

Sur la figure 3, on a par ailleurs représenté, de façon plus détaillée, le système de déplacement 21 du porte-échantillon 18b.

Lors de l'utilisation de deux échantillons de part et d'autre de l'enceinte à plasma 4a, on utilise non plus une seule enceinte de traitement, comme représenté sur la figure 1, mais deux enceintes de traitement 16a et 16b disposées de part et d'autre de l'enceinte à plasma 4a. Ceci apparaît en particulier sur la figure 4 montrant une machine industrielle permettant le traitement simultané de plusieurs échantillons.

En particulier, la machine représentée sur la figure 4 est une machine industrielle spécialement developpée

pour la réalisation de matrices d'écrans plats selon le procédé décrit dans le document FR-A-2 533 072.

Dans ce cas, la machine de traitement comporte trois réacteurs 52, 54 et 56 disposés en ligne permettant de traiter deux échantillons montés respectivement sur les porte-échantillons 18a et 18b mobiles, disposés verticalement. Les réacteurs 52, 54 et 56 sont alimentés en des gaz différents de façon à déposer successivement différentes couches sur les deux échantillons.

Par exemple, il est possible de déposer successivement sur un substrat de verre une couche de silicium amorphe hydrogéné (a-Si:H) dopé n+, puis une couche de a-Si:H non dopé (ou intrinsèque) et enfin une couche de $Si_3N_4$. Dans ce cas, les tubes 26c du réacteur 52 sont alimentés en $SiH_4$ et $PH_3$, les tubes 26d du réacteur 54 sont alimentés en $SiH_4$ et les tubes 26e du réacteur 56 sont alimentés en $SiH_4$+$NH_3$.

La figure 4 est une vue de dessus au niveau des enceintes à plasma. Pour chaque réacteur, on trouve bien évidemment, une source d'ondes hyperfréquences, un isolateur de micro-ondes, un cornet et des guides d'ondes dont l'un est équipé d'un piston pour assurer le couplage de chaque enceinte à plasma avec la source correspondante.

Les chambres à plasma et les éléments de couplage de ces chambres aux sources sont tous alignés selon l'axe z de la machine. Les sources hyperfréquences peuvent quant à elles être disposées en-dessous et connectées aux guides linéaires à l'aide de guides coudés afin de réduire l'encombrement longitudinal de la machine.

Pour le dépôt des couches de a-Si:H et de $Si_3N_4$, la dissociation des gaz conduit principalement à la formation d'hydrogène et d'azote atomiques ou moléculaires. Dans le but d'éviter une éventuelle retrodiffusion de l'azote vers les réacteurs 52 et 54 de dépôt de silicium amorphe, qui pourrait altérer la qualité de ce dépôt, le raccordement des systèmes de pompage des enceintes de traitement respectivement 16a et 16b se fait au niveau du réacteur 56 de dépôt de nitrure de silicium.

Chaque enceinte de traitement 16a et 16b est donc reliée à une pompe à vide 50a et 50b disposée de part et d'autre des enceintes de traitement.

Les groupes de pompage sont par exemple du type ROOTS capables d'absorber l'important flux gazeux dirigé dans le sens de déplacement des porte-échantillons 18a et 18b. Il est également envisageable de n'utiliser qu'une seule pompe reliée à des canalisations parfaitement symétriques raccordées aux enceintes 16a et 16b.

La machine représentée sur la figure 4 est compacte et peut être raccordée à des modules standards permettant le chargement des échantillons sur les porte-échantillons ainsi que le chauffage de ces échantillons avant leur mise dans les enceintes de traitement.

Avec cette machine, il est possible de réaliser des matrices actives d'écrans plats de grandes dimensions, typiquement de $1m^2$, avec des vitesses de dépôt et de gravure des différentes couches de 10 à 100 fois plus élevées que celles de l'art antérieur.

Les réacteurs et machine décrits précédemment aux figures 1 à 4 peuvent être utilisés aussi bien pour le depôt de couches minces ou épaisses que pour la gravure de ces couches. La nature des gaz utilisés pour la formation des plasmas dépend donc du type de traitement à réaliser.

Des plasmas, dans une large gamme de pression et de débit sont obtenus avec des gaz neutres comme l'argon, l'hélium, mais aussi avec des gaz purs traditionnellement utilisés en microélectronique comme $SiH_4$, $PH_3$, $N_2$, $H_2$, $SF_6$, $NH_3$, $O_2$, etc. Des plasmas d'air peuvent également être créés dans les mêmes domaines de pression et de débit.

Les débits de gaz utilisés sont compris entre 10 et $100cm^3/min$. L'usage de débits beaucoup plus importants peut être envisagé en augmentant la capacité de pompage du ou des groupes à vide et notamment en utilisant un système de pompage du type ROOTS. En particulier, des débits de l'ordre de $500cm^3/min$ sont envisageables.

Des plasmas stables peuvent être envisagés avec les réacteurs et machine de l'invention dans un domaine de pressions compris entre 1 et 30Pa. Ce domaine de pressions est également fonction du groupe de pompage utilisé.

Dans ces conditions de pression et de debit de gaz, le temps de résidence des espèces gazeuses dans chaque réacteur à plasma est compris entre 0,1 et 60 secondes.

Pour une enceinte à plasma selon la figure 1 raccordée à un cornet de couplage de section de $100cm^2$, la densité électronique du plasma a été evaluée par des mesures de sonde de Langmuir entre $10^{11}$ et $10^{13}$ électrons/$cm^2$.

Cette densité électronique est à comparer à celle obtenue dans les plasmas utilisant le mode d'excitation ECR et les plasmas du type PECVD. Le tableau suivant donne les valeurs des densités électroniques (ne) obtenues dans ces différents plasmas.

Dans ce tableau, le plasma objet de la présente invention est noté TWMP (Transverse Waveguide Microwave Plasma en terminologie anglo-saxonne).

| | TWMP | ECR | PECVD |
|---|---|---|---|
| ne | $10^{11}$ à $10^{13}$ | $10^{9}$ à $10^{11}$ | $10^{8}$ à $10^{9}$ |

Les densités électroniques très élevées obtenues avec le réacteur de l'invention ont pour effet de conduire, pour les gaz moléculaires, à de forts taux de dissociation. Des mesures effectuées au RGA (Analyseur de Gaz Résiduel) montrent pour des plasmas de silane ($SiH_4$) que tout le gaz injecté dans l'enceinte à plasma est dissocié.

Les spectres enregistrés sur un tel plasma sont donnés dans les figures 5a et 5b. Ces spectres donnent l'intensité des pics d'émission A en fonction des unités de masse atomique.

La figure 5a correspond à l'enregistrement effectué lorsque le silane est introduit dans l'enceinte à plasma avant l'amorçage du plasma.

Les pics de masse atomique 28-29-30-31-32 correspondant aux radicaux SiHn (avec n=0 à 4) sont ceux introduits dans la chambre à ionisation du RGA. Ce spectre correspond donc au spectre de référence de la chaîne de mesure.

La figure 5b correspond au spectre enregistré après amorçage du plasma. Aucun des pics mesurés précédemment n'est détectable au maximum de sensibilité de la chaîne de mesure RGA.

On conclut donc que suivant un mécanisme de dissociation du type : $SiH_4$ + e - - - >SI + 4H + e, toutes les molécules de silane sont dissociées et que tout le silicium atomique ainsi créé se dépose sur le substrat et les parois du réacteur.

Une des conséquences de ce fort taux de dissociation est de faire chuter brutalement la pression lors de l'amorçage du plasma. Par exemple pour du silane, les pressions avant et après amorçage du plasma sont quasiment dans un rapport de deux.

Pour une rampe d'injection de gaz fixée à l'intérieur de l'enceinte à plasma et un substrat placé à 10cm de cette rampe, les vitesses de dépôt observées sont de l'ordre de 2 à 6nm/s.

Plus particulièrement, les vitesses de dépôt obtenues pour des films de a-Si:H et de $Si_3N_4$ sont de l'ordre de 3 à 4nm/s, c'est-à-dire des vitesses d'un bon ordre de grandeur supérieur à celui obtenu par d'autres techniques de dépôt.

Dans un réacteur de l'invention, la vitesse de dépôt est fortement influencée par le débit du gaz injecté et par la distance séparant la rampe à injection du substrat.

En effet, les inventeurs ont démontré que dans ce réacteur le taux de dissociation des gaz moléculaires est de 100% ; il en résulte que la vitesse de dépôt au niveau du substrat n'est en aucune manière influencée par le gradient de la densité électronique du plasma mais est uniquement fonction des espèces créées dans le plasma.

Si la distance entre le substrat et la rampe d'injection est ramenée à 4cm alors pour le même débit gazeux, les vitesses de dépôt sont comprises entre 6 et 18nm/s.

Les inventeurs ont également montré la possibilité d'obtenir des vitesses de gravure élevées sur des films minces comme par exemple a-Si:H ou $Si_3N_4$ ou sur des films de résine photosensible.

Sous l'action d'un plasma d'oxygène pur (02), un film de résine photosensible d'une épaisseur de 1,3µm est totalement gravé en un temps inférieur à 2 minutes.

Sans aucune polarisation du substrat, les vitesses de gravure de la résine obtenues sont donc supérieures à 10nm/s et donc supérieures à celles obtenues avec les dispositifs de gravure de l'art antérieur.

Par ailleurs, le dispositif de l'invention permet, après chaque type de gravure ou de dépôt de couches, le nettoyage par plasma des réacteurs ou machines de traitement. Ainsi, un plasma d'$Ar/SF_6$ permet notamment d'obtenir des vitesses de gravure des films déposés sur les parois au moins égales à celles obtenues pour le dépôt.

Avec le réacteur de l'invention, trois types de dépôts ont été effectués et caractérisés en vue de réaliser les transistors en couches minces d'une matrice active pour écrans plats à cristaux liquides. Ces matériaux sont le nitrure de silicium, le silicium amorphe hydrogené non intentionnellement dopé et le silicium amorphe hydrogéné dopé n+.

On rapporte ci-après les principales propriétés de ces matériaux.

EXEMPLE 1 : Dépôt du nitrure de silicium.

Le dépôt de couches minces de nitrure de silicium est obtenu par décomposition d'un mélange de gaz de $SiH_4$ et $NH_3$.

Les conditions expérimentales permettant l'obtention d'un matériau de qualité sont résumées ci-après.

- pression : 2 à 20Pa,
- rapport des débits $NH_3/SiH_4$ : de 1,5 à 2,5,
- température : 100 à 230°C.

Le nitrure de silicium étant utilisé comme isolant de grille du transistor, il doit posséder de bonnes propriétés diélectriques. En particulier, le courant de fuite du matériau sous fort champ électrique doit être aussi faible que possible.

La figure 6a montre la structure de l'échantillon étudié. Elle comporte une couche de nitrure de silicium 58 déposée sur une plaquette 52 de silicium monocristallin dégénéré, utilisée comme substrat conducteur et recouverte d'une électrode d'aluminium 60.

La couche de nitrure de silicium a une épaisseur de 180nm et la couche d'aluminium une épaisseur de 200nm. La surface du plot d'aluminium est de 0,3mm$^2$.

Les conditions de dépôt du nitrure de silicium utilisées pour réaliser la structure de la figure 6a sont les suivantes :

- pression : 2,4Pa,
- débit $SiH_4$ : 30cm$^3$/min,
- débit $NH_3$ : 50cm$^3$/min,
- puissance : 800W,
- température : 200°C,
- vitesse dépôt : 1,5nm/s.

Le montage électrique utilisé pour tester la structure de la figure 6a est représenté sur la figure 6b, elle comporte une source d'alimentation électrique alternative 61 dont les bornes sont connectées au condensateur C représentant la structure à mesurer et à une résistance r montée en série. La mesure de la tension (v) apparaissant aux bornes de la résistance r permet de déterminer le courant I traversant le montage.

La caractéristique courant-tension obtenue est représentée sur la figure 6c. Elle donne les variations de l'intensité I exprimée en ampères en fonction de la tension U exprimée en volts. Cette caractéristique ne fait apparaître que la composante capacitive (courant de charge du condensateur $Si_3N_4$), ce qui traduit une résistivité très élevée ($\rho > 10^{14}$ ohms/cm) même en champ fort (3MV/cm) et donc de bonnes propriétés isolantes.

Les caractérisations effectuées montrent que les propriétés physicochimiques du matériau $Si_3N_4$ déposé par plasma haute fréquence selon l'invention sont de même nature que celles obtenues pour des films déposés par PECVD.

<u>EXEMPLE 2</u> : Dépôt du silicium amorphe hydrogéné non dopé.

Le dépôt de couches minces ou épaisses de silicium amorphe hydrogéné a-Si:H est obtenu à l'aide d'un plasma de silane pur dans des conditions suivantes :

- pression : 2 à 20Pa,
- température : 100 à 230°C.

Ces couches peuvent avoir une épaisseur de 50nm à 20µm selon l'application envisagée.

Il est connu de l'homme de l'art que les propriétés semi-conductrices de ce matériau sont optimisées lorsque la concentration d'hydrogène atomique est proche de 8 à 10%. Cet hydrogène doit être lié au silicium principalement sous la forme de liaisons Si-H, au détriment des autres liaisons possibles H-Si-H et

```
H-Si-H.
     |
     H
```

La spectroscopie vibrationnelle infrarouge se révèle être la méthode la plus rapide et la mieux adaptée pour de telles études structurales à l'échelle microphysique.

La figure 7 donne la transmittance (T%) d'un film de a-Si:H dans la région de 1900 à 2300cm$^{-1}$. N représente le nombre d'ondes.

On remarque la présence d'une bande principale dont la fréquence au maximum est proche de 2000cm$^{-1}$, correspondant aux liaisons Si-H.

L'etude précise du profil de cette bande principale montre un épaulement dans la région des 2100cm$^{-1}$. Cet épaulement est attribué à une bande de faible intensité correspondant aux liaisons H-Si-H.

La concentration d'hydrogène calculée à partir de la surface totale du massif est de 7%. Il apparaît donc que le matériau déposé suivant l'invention présente une concentration d'hydrogène équivalente à celle déterminée en PECVD.

Cette caractérisation rapide permet d'affirmer que le matériau déposé est un "bon semi-conducteur". Ceci

est confirmé par la mesure des caractéristiques électriques des transistors réalisés et par le calcul de la mobilité effective des porteurs à partir d'un modèle analytique simulant le fonctionnement de ces mêmes transistors.

EXEMPLE 3 : Dépôt du silicium amorphe hydrogéné dopé.

Le dépôt est réalisé à partir d'un mélange de silane et de phosphine diluée à 5% dans de l'hélium (He - 5% $PH_3$).

Les conditions expérimentales sont les suivantes :

- pression : 2 à 20Pa,
- température : 100 à 230°C.

La conductivité laterale (ou de surface) des films mesurés est comprise entre $10^{-4}$ et $2x10^{-3}$ $ohm^{-1}.cm^{-1}$. Ces valeurs comparables à celles obtenues en PECVD permettent de réaliser des contacts ohmiques entre l'ITO (oxyde d'indium et d'étain) des source et drain et le a-Si:H.

EXEMPLES 4 et 5 :

Deux structures de transistors en couches minces ont été réalisées : une structure dite empilée à grille dessous dont la structure est représentée sur la figure 8a et une structure dite empilée à grille dessus dont la structure est représentée sur la figure 9a.

Les caractéristiques (ID)-(VD) de ces transistors sont également données respectivement sur les figures 8b et 9b.

Les courants ID sont donnés en microampères et les tensions VD de drain-source en volts. A chaque courbe correspond une tension de grille VG.

Le transistor de la figure 8a comporte un substrat 70 en verre sur lequel est formée la grille métallique 72 en aluminium de 200nm d'épaisseur ; elle est recouverte de l'isolant de grille 74 en nitrure de silicium de 300nm d'épaisseur. On trouve ensuite une couche 76 de silicium amorphe hydrogéné de 100nm d'épaisseur et une couche 77 de silicium amorphe hydrogéné dopé n+ de 50nm sur laquelle sont formés la source 78 et le drain 80 dans une couche d'ITO (oxyde d'indium et d'étain) de 200nm d'épaisseur. Le canal a une longueur de 40μm et une largeur de 10μm.

Le transistor de la figure 9a comporte aussi un substrat de verre 70 sur lequel sont formés directement les contacts 78 et 80 de source et drain en ITO. Ces contacts 78 et 80 sont recouverts d'une couche 77 de silicium amorphe hydrogéné dopé n+. On trouve alors la couche de silicium amorphe hydrogéné 76 puis l'isolant de grille 74 et enfin la grille métallique 72. Les épaisseurs des couches 78, 77, 76, 74 et 72 sont les mêmes que ci-dessus ; le canal a une largeur de 40μm et une longueur de 10μm.

Le transistor à grille dessus est réalisé conformément au document FR-A-2 533 072.

Les différentes couches des transistors déposées ainsi que leur gravure pour définir les dimensions de ces transistors ont été réalisées avec le réacteur conforme à l'invention.

La mobilité effective des électrons dans le canal de ces transistors a été calculée par une méthode d'extraction de paramètres, basée sur un modèle analytique du fonctionnement de ces transistors.

Dans le cas d'un transistor à grille dessous, la mobilité est de $0,5cm^2/V.s$.

A titre de comparaison, les valeurs publiées à ce jour pour une telle structure sont typiquement comprises entre 0,3 et $1cm^2/V.s$.

Les résultats donnés ici peuvent bien entendu être améliorés et l'on peut raisonnablement estimer que, lorsque les conditions optimum de fabrication seront atteintes, des valeurs de mobilité plus élevées pourront être obtenues.

Les résultats présentés ici sont ceux obtenus avec des films minces déposés à des pressions de l'ordre de 1 à 10Pa.

Les inventeurs ont cependant noté que des films déposés à des pressions plus élevées, c'est-à-dire entre 20 et 50Pa conservent les propriétés physicochimiques recherchées. Ainsi, étant donné qu'il est possible de travailler à haute pression, on conçoit immédiatement qu'en utilisant un système de pompage à vide du réacteur qui accepte de forts debits de gaz, il est alors envisageable d'obtenir des vitesses de dépôt très élevées, de l'ordre de 10 à 20nm/s.

Les courbes représentées sur les figures 8b et 9b sont comparables à celles obtenues avec des réacteurs PECVD de l'art antérieur.

Avec le dispositif de l'invention, il est en outre possible de déposer des couches épaisses ≧10μm notamment en a-Si:H sur un substrat en verre (sado-calcique notamment) afin de réaliser des dispositifs à conversion d'énergie lumineuse (ou cellules solaires).

## Revendications

1. Dispositif à plasma de traitement chimique comportant une source d'ondes électromagnétiques de haute fréquence (2), une enceinte à plasma fermée (4, 4a), equipée de moyens (26, 26a, 26b) d'alimentation en gaz destiné à former le plasma, des éléments de couplage de la source à l'enceinte à plasma, des moyens de pompage (50) de l'enceinte à plasma et au moins un porte-échantillon (18, 18a), caractérisé en ce que l'enceinte à plasma est non rayonnante et a la forme d'un parallélépipède rectangle avec une première et une seconde faces en matériau diélectrique (8, 10), parallèles à une première direction ( $\vec{H_x}$ ) et une troisième face (12) équipée d'une ouverture rectangulaire (14, 14a) orientée selon la première direction pour former un plasma en forme de ruban, ladite ouverture mettant en communication l'enceinte à plasma (4, 4a) et une enceinte de traitement (16, 16a) dans laquelle est logé le porte-échantillon, en ce que les moyens de couplage comportent un premier guide d'ondes (30) linéaire de section rectangulaire, orienté selon une seconde direction ( $\vec{P}$ ) perpendiculaire aux premières et seconde faces, un cornet (36) pour coupler le premier guide à l'enceinte à plasma, via la première face, dont la section rectangulaire s'élargit selon la première direction du premier guide vers l'enceinte à plasma, un second guide d'ondes (38) linéaire à section rectangulaire, orienté selon la seconde direction et disposé du côté de l'enceinte à plasma opposé à celui du premier guide, ce second guide étant muni d'un court-circuit (46) auxdites ondes électromagnétiques.

2. Dispositif selon la revendication 1, caractérisé en ce que les moyens d'alimentation en gaz consistent en au moins un tube (26) percé de trous (28) sur toute sa longueur qui débouchent dans l'enceinte à plasma, ces tubes étant orientés parallèlement à la première direction.

3. Dispositif selon la revendication 1, caractérisé en ce que les moyens d'alimentation en gaz comportent deux tubes (26a, 26b) orientés selon la première direction, les trous (28) de ces tubes étant orientés vers le centre de l'enceinte à plasma.

4. Dispositif selon la revendication 2, caractérisé en ce que les moyens d'alimentation en gaz comportent un seul tube (26) dont les trous (28) sont orientés vers l'ouverture (14) rectangulaire de l'enceinte à plasma.

5. Dispositif selon l'une quelconque des revendications 2 à 4, caractérisé en ce que le ou les tubes sont situés à proximité de l'ouverture rectangulaire de l'enceinte à plasma.

6. Dispositif selon l'une quelconque des revendications 1 à 5, caractérisé en ce que l'enceinte à plasma comporte une autre ouverture (14b) rectangulaire, orientée selon la première direction et formée dans une quatrième face (42) de l'enceinte à plasma, parallèle à la troisième face (12) mettant en communication l'enceinte à plasma (4a) et l'enceinte de traitement et en ce qu'un autre porte-échantillon (18b), logé dans une autre enceinte de traitement (16b) est prévu en regard de cette autre ouverture.

7. Dispositif selon l'une quelconque des revendications 1 à 6, caractérisé en ce que des moyens d'adaptation (34) de la longueur d'onde émise par la source d'ondes haute fréquence sont prévus dans le premier guide d'ondes.

8. Dispositif selon l'une quelconque des revendications 1 à 7, caractérisé en ce qu'un circuit isolateur (32) est prévu entre la source d'ondes haute fréquence et le premier guide d'ondes.

9. Dispositif selon l'une quelconque des revendications 1 à 8, caractérisé en ce que les première et seconde faces (8, 10) de l'enceinte à plasma sont montées à l'aide de brides métalliques (40) sur respectivement le cornet (36) et le second guide d'ondes (38), l'étanchéité au niveau des brides étant assurée à l'aide de joints toriques métalliques souples (44).

10. Dispositif selon l'une quelconque des revendications 1 à 9, caractérisé en ce que des moyens de déplacement (21) du porte-échantillon selon la première direction sont prévus.

11. Machine industrielle à plasma de traitement chimique de plusieurs échantillons, caractérisée en ce qu'elle comporte plusieurs dispositifs (52, 54, 56) selon l'une quelconque des revendications 1 à 10, disposés

les uns à la suite des autres et en ce qu'elle comprend au moins une enceinte de traitement (16a, 16b) commune à ces différents dispositifs contenant les porte-échantillons (18a, 18b) de ces dispositifs.

**12.** Procédé de dépôt d'une couche mince sur un substrat, caractérisé en ce que l'on place le substrat sur le porte-échantillon (18) du dispositif selon l'une quelconque des revendications 1 à 10, et en ce qu'on soumet le substrat (20) à un plasma engendré dans l'enceinte à plasma (4) de ce dispositif, précurseur de ladite couche mince.

**13.** Procédé de dépôt d'une couche de silicium amorphe hydrogéné sur un substrat, caractérisé en ce qu'on place le substrat (20) sur le porte-échantillon (18) du dispositif selon l'une quelconque des revendications 1 à 10, et en ce qu'on soumet le substrat à au moins un plasma de silane, engendré dans l'enceinte à plasma (4) de ce dispositif.

**14.** Procédé de dépôt selon la revendication 13, caractérisé en ce que la couche de silicium amorphe hydrogéné a une épaisseur $\geqq 10 \mu m$.

**15.** Procédé de dépôt d'une couche mince de nitrure de silicium sur un substrat, caractérisé en ce qu'on place le substrat (20) sur le porte-échantillon (18) du dispositif selon l'une quelconque des revendications 1 à 10, et en ce qu'on soumet le substrat à un plasma de silane et d'ammoniac, engendré dans l'enceinte à plasma (4) de ce dispositif.

**16.** Procédé de gravure par plasma d'un échantillon, caractérisé en ce qu'on place l'échantillon sur le porte-échantillon (18) du dispositif selon l'une quelconque des revendications 1 à 10, et en ce qu'on soumet cet échantillon à un plasma engendré dans l'enceinte à plasma de ce dispositif, apte à graver ledit échantillon.

**17.** Procédé selon l'une quelconque des revendications 12 à 16, caractérisé en ce que la pression régnant dans l'enceinte à plasma et l'enceinte de traitement est de 1 à 50Pa.

**18.** Procédé selon l'une quelconque des revendications 12 à 17, caractérisé en ce qu'on règle la distance séparant le ou les tubes d'alimentation en gaz et le porte-échantillon à une valeur au plus égale à 10cm.

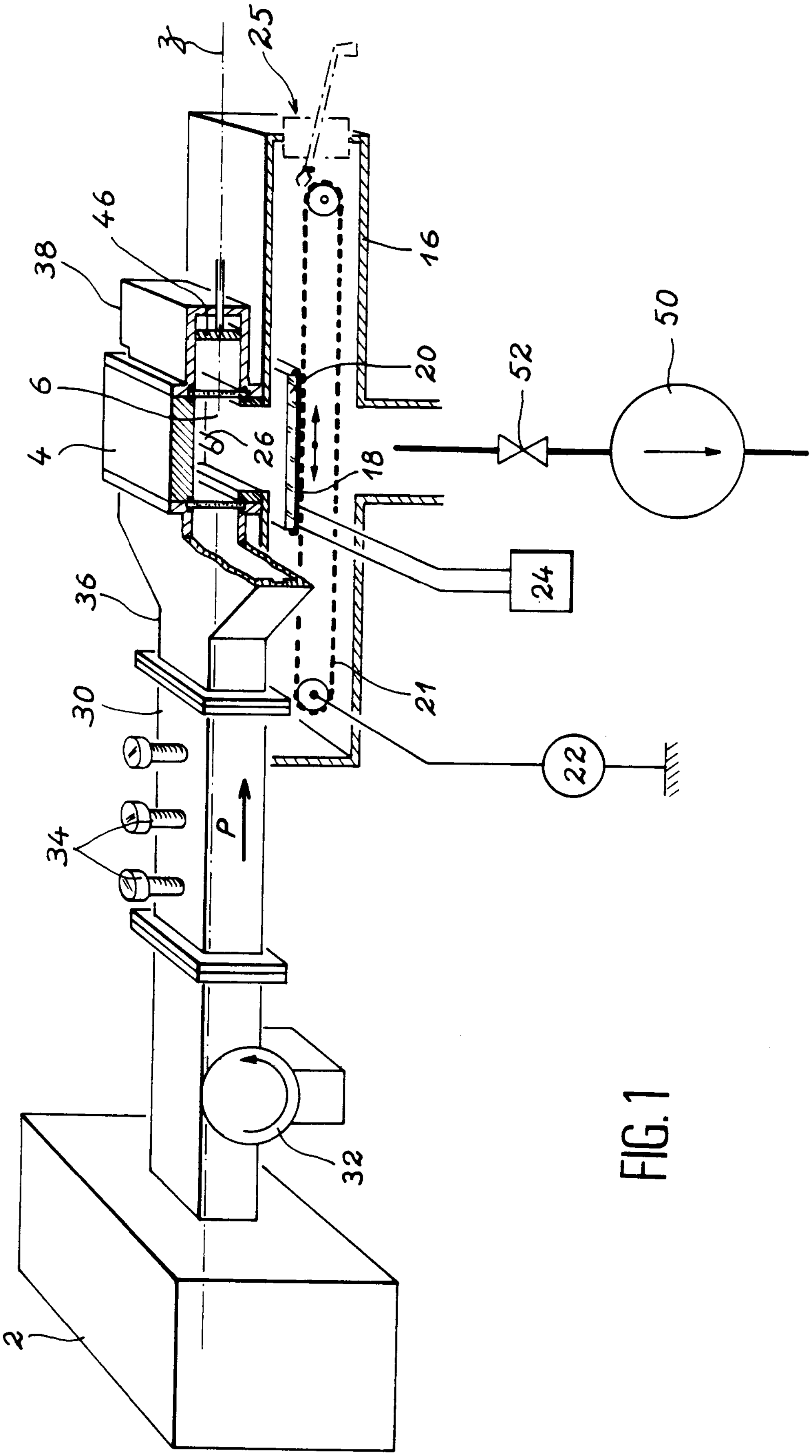


FIG. 1

FIG. 2

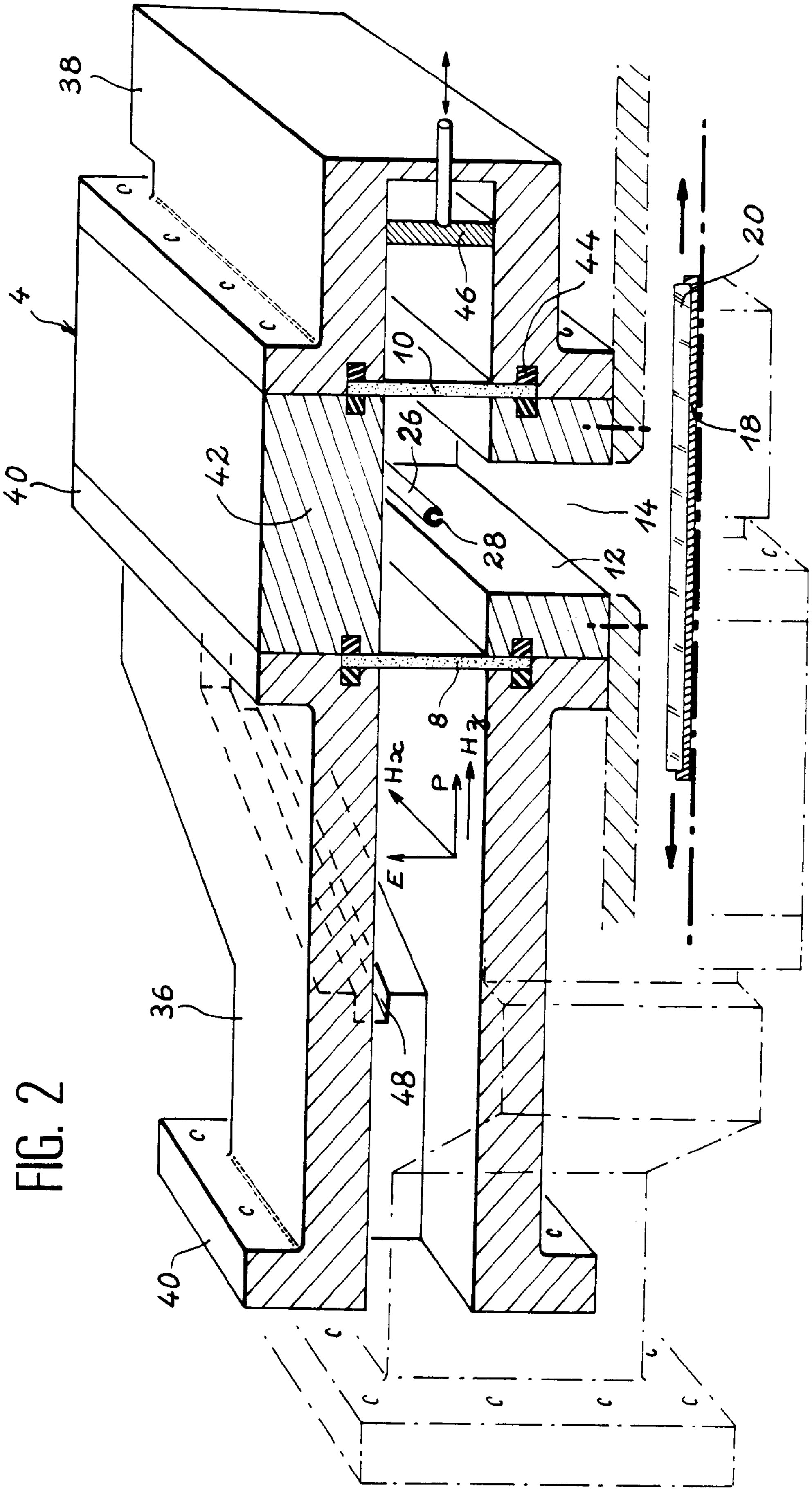

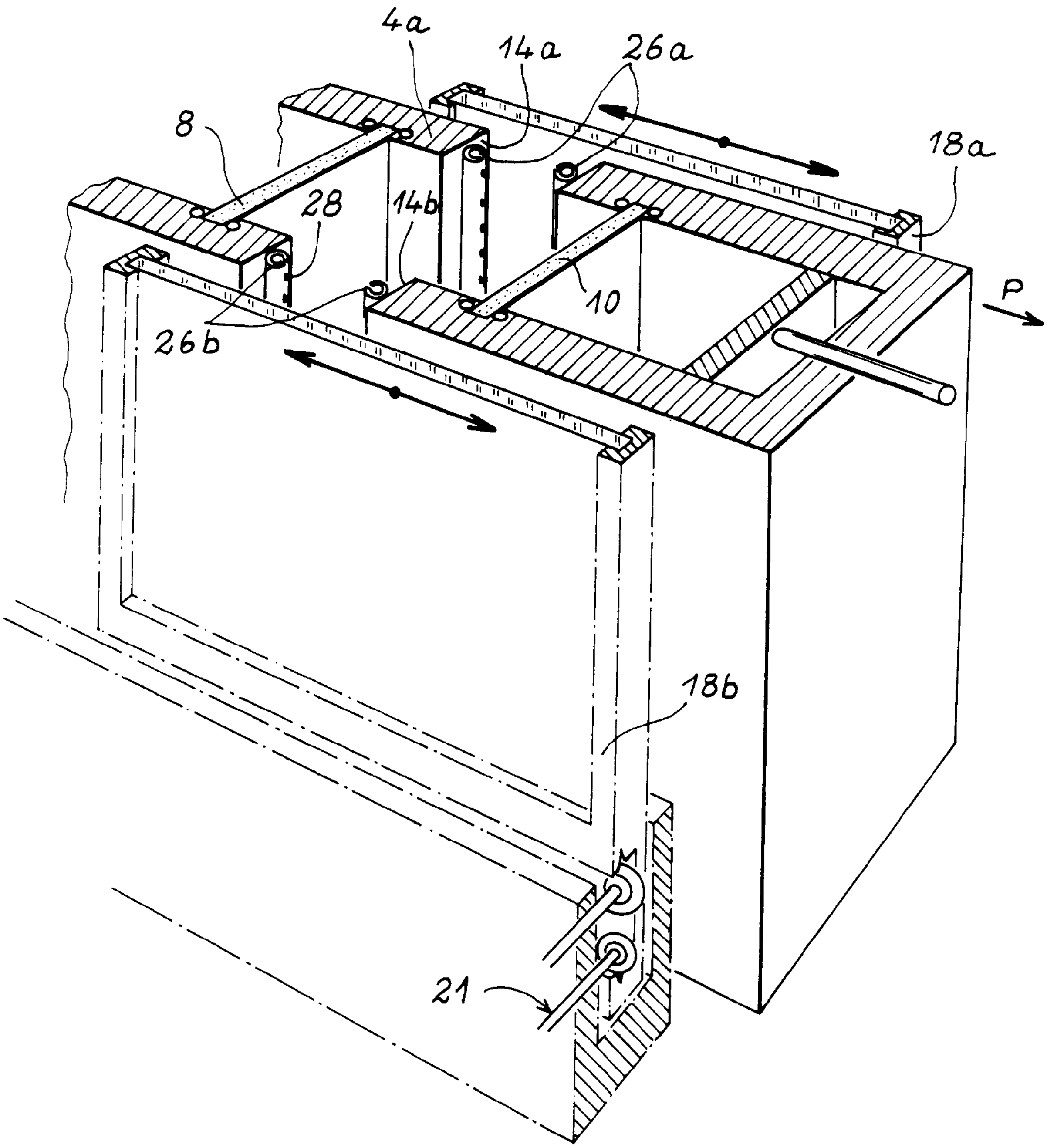


FIG. 3

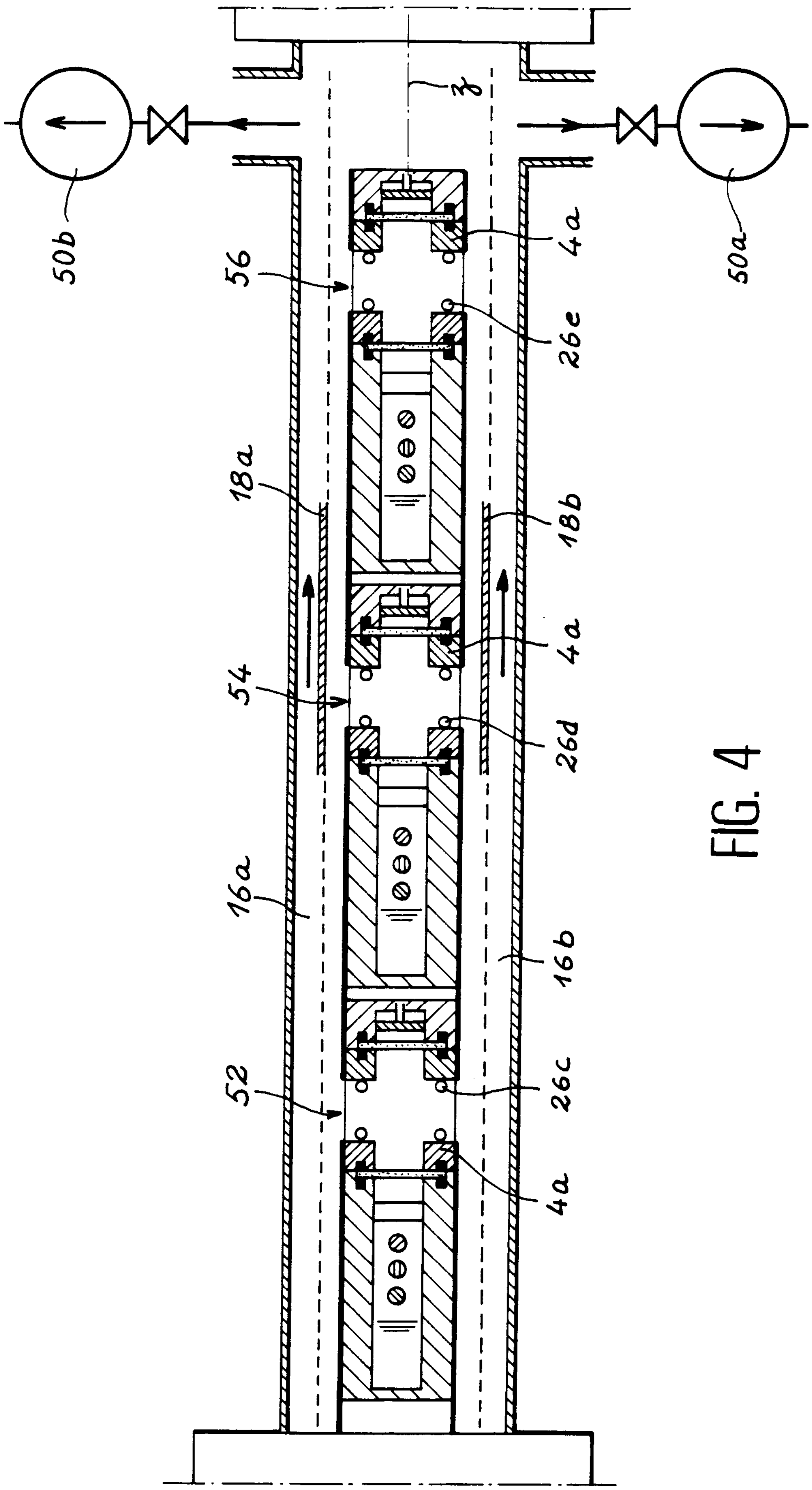


FIG. 4

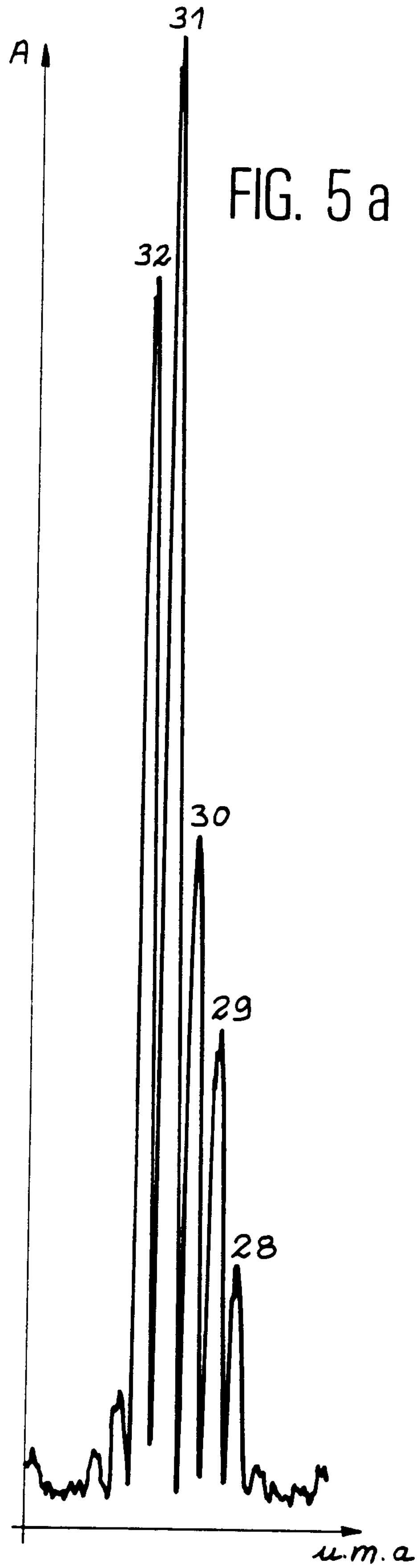


FIG. 5 a

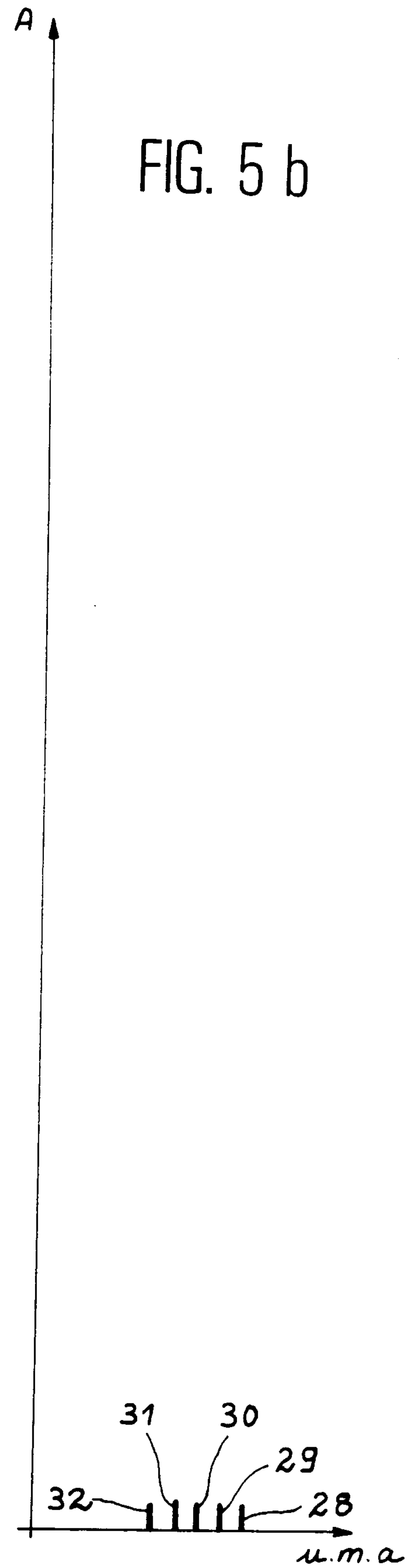


FIG. 5 b

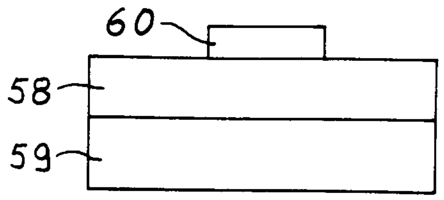


FIG. 6a

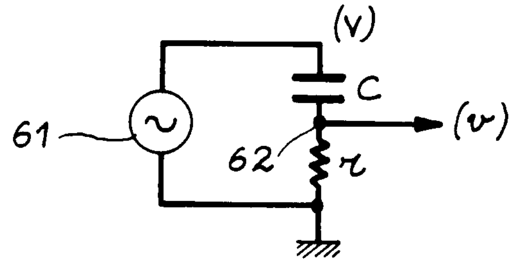


FIG. 6b

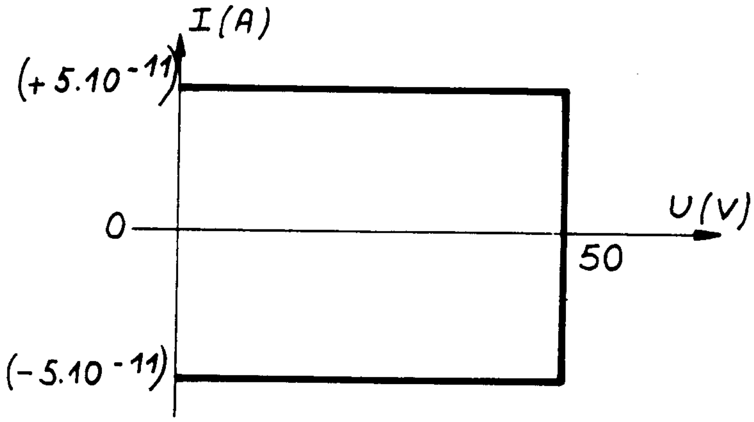


FIG. 6c

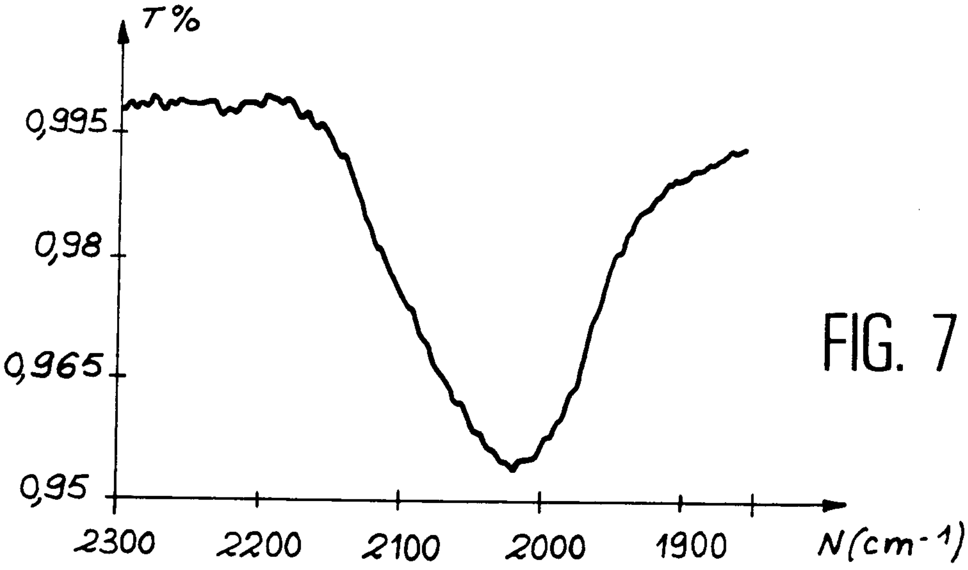


FIG. 7

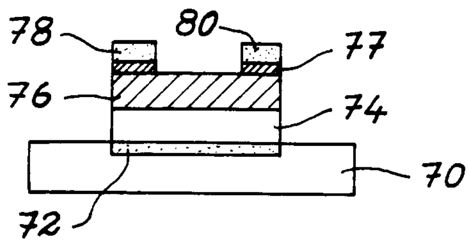


FIG. 8 a

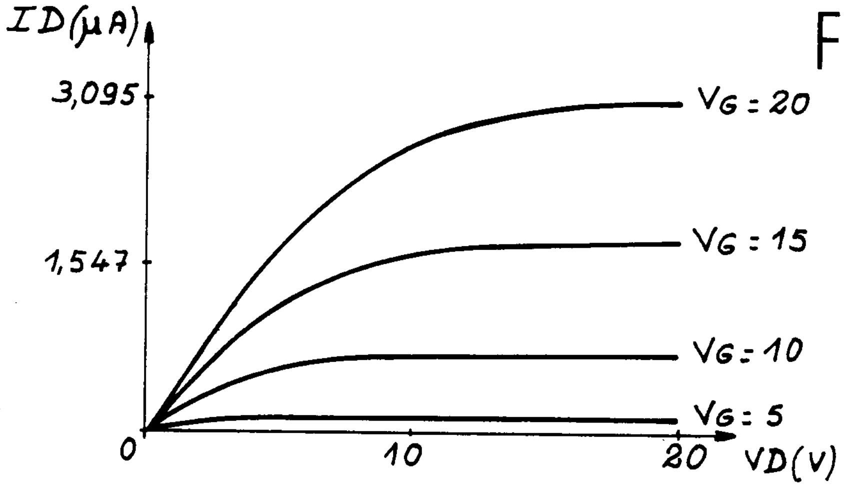


FIG. 8 b

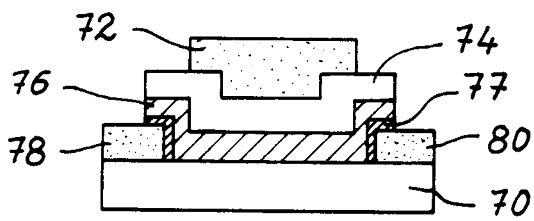


FIG. 9 a

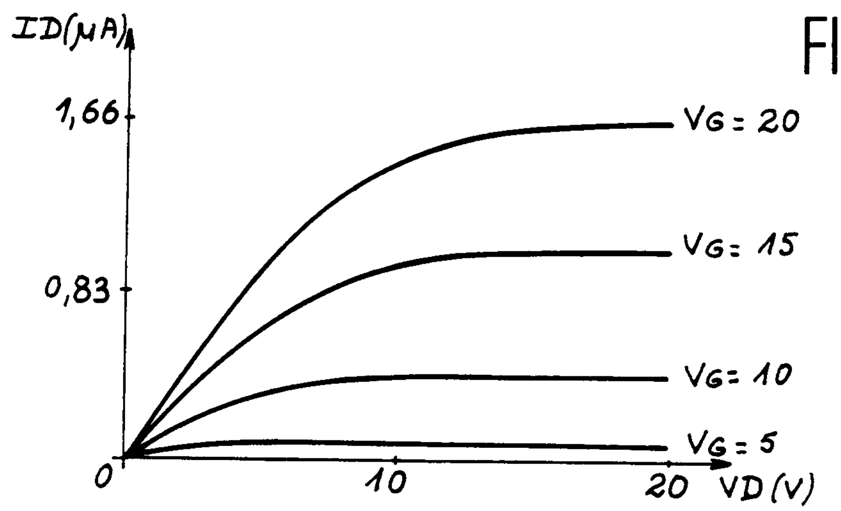


FIG. 9 b

Office européen des brevets

# RAPPORT DE RECHERCHE EUROPEENNE

Numero de la demande

EP 93 40 1159

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| D,A | EP-A-0 398 832 (DEFITECH S.A.)<br>* abrégé *<br>* colonne 7, ligne 3 - ligne 16 *<br>* colonne 8, ligne 20 - ligne 32 *<br>* colonne 9, ligne 26 - ligne 48 *<br>* colonne 14, ligne 55 - colonne 15, ligne 35 *<br>* colonne 15, ligne 48 - ligne 58; figures 1,2,10,11 *<br>--- | 1,7,11, 12 | H05H1/46<br>C23C16/42<br>C23F1/02<br>H01J37/32 |
| A | PATENT ABSTRACTS OF JAPAN<br>vol. 14, no. 338 (E-954)20 Juillet 1990<br>& JP-A-02 114 530 ( MITSUBISHI ELECTRIC ) 26 Avril 1990<br>* abrégé *<br>--- | 2-5 | |
| A | US-A-5 110 437 (YAMADA ET AL.)<br>* colonne 2, ligne 46 - ligne 58; revendication 1; figure 2 *<br>--- | 2,4,5 | |
| | | | DOMAINES TECHNIQUES RECHERCHES (Int. Cl.5 ) |
| A | PATENT ABSTRACTS OF JAPAN<br>vol. 11, no. 112 (P-565)9 Avril 1987<br>& JP-A-61 260 219 ( SEIKO INSTRUMENTS ) 18 Novembre 1986<br>* abrégé *<br>--- | 13-15 | H01J<br>H05H |
| A | EP-A-0 279 895 (LEYBOLD-HERAEUS)<br>* abrégé *<br>* colonne 5, ligne 13 - ligne 42; figure 1 *<br>--- | 1 | |
| A | EP-A-0 422 430 (TECHNICS PLASMA)<br>* abrégé *<br>* colonne 3, alinéa 2 -alinéa 3; figure 1 *<br>----- | 9 | |

Le présent rapport a été établi pour toutes les revendications

| Lieu de la recherche | Date d'achèvement de la recherche | Examinateur |
|---|---|---|
| LA HAYE | 16 AOUT 1993 | GREISER N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)